# EUROPÄISCHE PATENTSCHRIFT

(11) **EP 0 766 090 B1**
(45) Veröffentlichungstag und Bekanntmachung des Hinweises auf die Patenterteilung: **11.04.2001**
(21) Anmeldenummer: 96114618.0
(22) Anmeldetag: 11.09.1996
(51) Int. Cl.: G01P 15/08

(54) **Mikroelektronischer, integrierter Sensor und Verfahren zur Herstellung des Sensors**
Microelectronic integrated sensor and method of manufacturing the same
Microcapteur électronique intégré et procédé pour sa fabrication

(30) Priorität: 28.09.1995 DE 19536250
(43) Veröffentlichungstag der Anmeldung: 02.04.1997
(73) Patentinhaber: Infineon Technologies AG, 81669 München (DE)
(72) Erfinder: Müller, Karlheinz, Ing., 84478 Waldkraiburg (DE); Kolb, Stefan, Dipl.-Ing. (FH), 85716 Unterschleissheim (DE)
(74) Vertreter: Zedlitz, Peter, Dipl.-Inf.

(56) Entgegenhaltungen:
- DE-A- 4 332 843
- US-A- 4 882 933
- US-A- 5 241 864
- US-A- 5 258 097

## Beschreibung

Die Erfindung betrifft einen mikroelektronischen, integrierten Sensor, in dem in ein Cantilever ausgebildet ist, und der insbesondere eine Stütze aufweist, die sich zur Abstützung der oberen Schichten durch einen Hohlraum erstreckt. Weiterhin betrifft die Erfindung ein Verfahren zur Herstellung des Sensors.

Derartige Sensoren werden beispielsweise zur Messung von Beschleunigungen eingesetzt. Beispielsweise ist in dem US-Patent 4,882,933 ein Beschleunigungssensor mit einem Cantilever beschrieben, der den Bewegungsbereich des Cantilevers begrenzt. In dem US-Patent 5,258,097 ist ein Verfahren angegeben, mit dem eine freischwebende Struktur, die an dem Substrat verankert ist, hergestellt werden kann.

Der Cantilever dient dabei zusammen mit einer oberen und einer unteren Elektrode als Kapazitätsreihenschaltung, wobei Kapazitätsänderungen als Meßgröße ausgewertet werden. Üblicherweise sind die bisher bekannten Cantilever über Federn im Sensor verankert. Die Prozeßabläufe bei der Herstellung des Sensors führen jedoch zu Streß, insbesondere mechanischem Streß, im Cantilever. Bei einer nicht vollständigen Relaxierung der Federn kann sich der Cantilever dadurch dauerhaft verbiegen. Weiterhin können die in den Federn aufgenommenen Kräfte zu einem Fehlverhalten des Cantilevers während des Betriebs führen. Zur mechanischen Stabilisierung dieser Sensoren werden obere Verschlußplatten, die in der Regel aus einer Polysiliziumschicht bestehen, mit Hilfe von Oxidstützen abgestützt.

In der Druckschrift US 5,241,864 wird beispielsweise ein mikromechanischer Sensor beschrieben, der an seinem Rand Stützen aufweist, die einen elektrischen Kontakt bilden. Die Druckschrift DE 43 32 843 beschreibt Stützen, die aus einer Schichtenfolge bestehen und so eine durchgehende mechanische Verbindung zwischen dem Substrat und einer Deckschicht bilden.

Ebenso können die Verschlußzeiten aus einer Metallisierung gebildet und mit Metallisierungsstützen abgestützt werden.
Bei Aluminiumstützen besteht jedoch das Problem, daß diese zur unteren Elektrode z.B. mittels einer Diode isoliert werden müssen. Trotzdem können noch Leckströme auftreten, die die Funktionalität des Sensors beeinträchtigen. Oxidstützen sind nur schwierig herzustellen, da ihre Gestaltung problematisch und stark von den Ätzzeiten abhängig ist.

Der Erfindung liegt die Aufgabe zugrunde, einen Sensor der eingangs genannten Art zu schaffen, der unempfindlich gegen mechanische Beanspruchung ist. Außerdem soll ein Verfahren zur Herstellung eines solchen Sensors geschaffen werden.

Die Lösung dieser Aufgabe erfolgt vorrichtungsmäßig mit den kennzeichnenden Merkmalen des Anspruchs 1 und verfahrensmäßig erfolgt die Lösung mit den Merkmalen des Anspruchs 4.

Nach einem wesentlichen Gedanken der Erfindung weist der mikroelektronische Sensor eine aus Nitrid bestehende Stütze auf, die sich durch den Hohlraum des Sensors erstreckt und dadurch die oberen in der Regel aus Polysilizium bestehenden Schichten des Sensors gegen den Boden abstützt. Dadurch wird eine Stabilitätserhöhung des Sensors erreicht, bei der keine elektrischen Isolationsprobleme auftreten.

Auf diese Weise wird ein vollständig und frei relaxierbarer Cantilever geschaffen, der auf dem Auflager, beispielsweise Lagerpunkten, aufgelegt ist, auf denen er sich im wesentlichen frei bewegen kann und seitlich und von oben soweit in seiner Bewegung begrenzt wird, daß ein Verschieben oder Abrutschen über die tragenden Lagerpunkte hinaus verhindert wird.

Das Auflager wird in einer besonders bevorzugten Ausführungsform aus einer Polysiliziumschicht hergestellt, so daß der direkte und ständige Kontakt des Cantilevers mit der Lagerung nur zwischen dem Polysilizium des Cantilevers und dem Polysilizium des Auflagers stattfindet.

Auflager und Bewegungsbegrenzung können günstigerweise auch als eine Einheit ausgebildet sein, wobei bevorzugt eine den Cantilever-Außenrand sacklochförmig umgebende Aufnahmeeinrichtung vorgesehen ist. Ebenso kann man hier auch von einer schlitzförmigen oder nutartigen Aufnahme des Cantilevers sprechen. Die Bewegungsbegrenzungen und das Auflager sind bevorzugt im gesamten Umfangsbereich des Cantilevers vorgesehen. Ebenso kann jedoch auch eine punktförmige Lagerung vorhanden sein.

Die Bewegungsbegrenzung kann auch dadurch funktionsmäßig in das Auflager integriert werden, daß der Cantilever abgestuft ausgebildet wird, so daß er einerseits auf dem Lagerpunkt aufliegt und die Stufe im Falle eines Verrutschens an den Lagerpunkten anschlagen würde. Durch Planisierung der Oxidschicht, auf der der Cantilever ausgebildet wird, ist auch die Herstellung eines geraden Cantilevers möglich.

In einer bevorzugten Ausführungsform ist die Bewegungsbegrenzung in Form einer Stütze ausgebildet, die durch eine im Cantilever gebildete Ausnehmung geführt wird. Die Bewegungsbegrenzung greift in diesem Fall also nicht an dem Außenrand des Cantilevers, sondern an dem in der Ausnehmung gebildeten Rand des Cantilevers an.

Nach einem weiteren Gedanken der Erfindung ist der Cantilever auf einem Auflager aufgelegt, sind seitliche und obere Bewegungsbegrenzungen vorhanden, die in der Weise von dem Rand des Cantilevers beabstandet sind, daß einerseits ausreichende Ausgleichsbewegungen des Cantilevers von mechanischem Streß möglich sind, und daß andererseits die Ausgleichsbewegungen nur im Bereich des Auflagers möglich sind. Die Nitridstützen sind bevorzugt mit einem Hohlraum ausgebildet, da diese Form besonders leicht herstellbar ist.

Bei dem Verfahren zur Herstellung eines mikroelektronischen, integrierten Sensors mit einem in einem Hohlraum ausgebildeten Cantilever wird nach einem wesentlichen Gedanken der Erfindung auf einem Substrat ein erstes Oxid erzeugt, eine erste Polysiliziumschicht abgeschieden und zur Bildung von einem Cantileverlager strukturiert, darauf eine zweite Oxidschicht abgeschieden, im nächsten Schritt eine zweite Siliziumschicht zur Cantileverbildung abgeschieden, dotiert und rekristallisiert, in der zweiten Polysiliziumschicht ein Löcherarray strukturiert, welches zum Durchleiten der am Ende des Prozeßablaufs durchgeführten Oxidätzung dient, eine dritte und vierte Oxidschicht aufgebracht und strukturiert, eine dritte Polysiliziumschicht zur Bildung eines Deckels aufgebracht, in der dritten Polysiliziumschicht ein Löcherarray strukturiert und durch dieses Löcherarray eine isotrope Ätzung der darunter liegenden vier Oxidschichten mit Ausnahme eines Teils der ersten Oxidschicht, die unter der Struktur der ersten Polysiliziumschicht liegt, zur Bildung des Hohlraums durchgeführt.

Mit diesem Verfahren wird ein Cantilever in einem Hohlraum innerhalb eines Sensors ausgebildet, der auf einem aus der ersten Polysiliziumschicht ausgebildeten Lagerpunkt aufliegt.

Um zu vermeiden, daß während der Oxidätzung zur Bildung des Hohlraums der aus der zweiten Polysiliziumschicht gebildete Cantilever sich auf der Polysiliziumschicht oder an einer anderen Fläche im Zusammenwirken mit der Ätzflüsigkeit festsaugt, ist es vorteilhaft, während des Herstellunsprozesses Lackstützen vorzusehen. Sie können auf einfache Weise durch eine zweistufige Erzeugung des Löcherarrays in der dritten Polysiliziumschicht gebildet werden. Dabei werden mit einer ersten Fototechnik über die Fläche verteilt Löcher strukturiert. Über diese Löcher wird zunächst eine anisotrope Oxidätzung mit einer teilweise isotropen Komponente durchgeführt. In die dabei erzeugten Hohlräume wird Lack eingebracht, indem zur Erzeugung der übrigen Löcher des Löcherarrays in der dritten Polysiliziumschicht erneut eine Lackmaske aufgebracht wird, die die jetzt zu erzeugenden Löcher frei läßt und die zuerst erzeugten Löcher abdeckt. Dabei füllen sich die vorher geätzten Hohlräume mit Lack und untergreifen aufgrund der isotropen Komponente der vorhergehenden Ätzung auch die zweite Polysiliziumschicht. Für die Ausbildung dieser Lackstützen ist es notwendig, daß die dafür verwendeten Löcher im Löcherarray der zweiten Polysiliziumschicht im wesentlichen mit den Löchern der dritten Polysiliziumschicht übereinstimmen. Abschließend wird der Lack aus dem vollständig geätzten Hohlraum entfernt, so daß der Cantilever frei beweglich angeordnet ist.

Nach einem weiteren wesentlichen Gedanken der Erfindung wird zur Bildung einer Stütze in dem Hohlraum des Sensors eine Verfahrensfolge angewandt, bei der verschiedene Oxidschichten aufgebracht werden, die später den Hohlraum bilden, auf die Oxidschichten eine später den Deckel bildende Polysiliziumschicht abgeschieden wird, diese mit einer Fototechnik strukturiert und anschließend geätzt wird, durch das geätzte Loch in der Polysiliziumschicht eine anisotrope Oxidätzung mit isotroper Komponente durchgeführt wird, eine Nitridbeschichtung aufgebracht wird, die auch den vorher geätzten Hohlraum füllt und so eine Nitridstütze bildet, und durch andere in der Polysiliziumschicht geätzte Löcher eine Oxidätzung zur Bildung des Hohlraums um den Pfeiler herum durchgeführt wird.

Bei der Ausbildung des Cantilevers, der aus einer zwischen den Oxidschichten angeordneten weiteren Polysiliziumschicht gebildet wird, ist es bevorzugt, an der Stelle der späteren Stütze eine größere Ausnehmung zu strukturieren, so daß die Stütze beabstandet von dem Cantilever durch diesen hindurchführt.

In der den Deckel bildenden Polysiliziumschicht wird günstigerweise ein Löcherarray erzeugt, durch die die späteren Ätzungen vorgenommen werden. Dabei wird ein Loch zur Durchführung der Schritte zur Nitridstützen-Herstellung ausgewählt und die darum herum liegenden Löcher zur Ätzung der Oxidschichten verwendet.

In einer Weiterbildung der Erfindung werden die verschiedenen Oxidschichten aus Materialien mit unterschiedlichen Ätzraten gebildet, so daß bei der Hohlraumätzung die Formung des gewünschten Hohlraums durch die Wahl einer Oxidschicht mit einer geeigneten Ätzrate gesteuert werden kann. In dieser Ausführungsform ist jedoch durch die Verwendung der ersten Polysiliziumschicht als Lagerpunkt und gleichzeitig als Ätzstop für einen Teil des darunter liegenden Oxids auch eine Vewendung von Oxidschichten mit gleicher Ätzrate möglich.

Nachfolgend wird die Erfindung anhand eines in der Zeichnung dargestellten Ausführungsbeispiels weiter erläutert. Im einzelnen zeigen die schematischen Darstellungen in:
- Figur 1: einen schematischen Querschnitt durch einen mikroelektronischen Sensor mit Cantilever und Nitridstütze während des Herstellungsverfahrens;
- Figur 2: einen mikroelektronischen Sensor mit Cantilever und Nitridstütze gegen Ende des Herstellungsverfahrens; und
- Figur 3: eine teilgeschnittene Draufsicht auf einen mikroelektronischen Sensor.

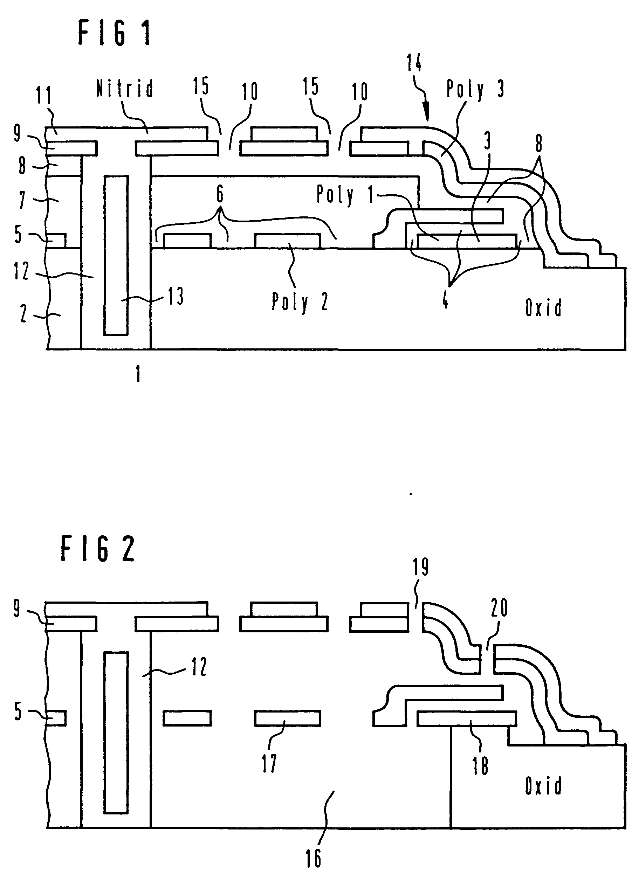

In Figur 1 sind die in verschiedenen Verfahrensschritten aufgebrachten und strukturierten Materialschichten dargestellt. Dabei wird ausgehend von einem Substrat 1 eine erste, relativ dicke Oxidschicht 2 erzeugt. Auf diese wird eine erste Polysiliziumschicht 3 aufgebracht, die mit einer Fototechnik strukturiert wird, um später einen Lagerpunkt für den Cantilever zu bilden. Danach wird eine zweite Oxidschicht 4 aufgebracht, deren wesentliche Aufgabe darin besteht, den aus der ersten Polysiliziumschicht 3 gebildeten Lagerpunkt 18 zu bedecken. Außerhalb dieses Bereichs wird die Oxidschicht wieder entfernt, so daß, wie in Figur 1 dargestellt, im nächsten Schritt eine zweite Polysiliziumschicht 5 aufgebracht werden kann. Es wäre jedoch ebenfalls möglich, diese zweite Oxidschicht 4 nicht in Teilbereichen wegzuätzen, so daß die zweite Polysiliziumschicht 5 dann komplett auf der Ebene der im rechten Bereich der Polysiliziumschicht 5 dargestellten erhöhten Stufe ausgebildet würde.

Die zweite Siliziumschicht 5 wird dotiert und mit einer Hochtemperaturbehandlung rekristallisiert und dabei auch die Dotierstoffe aktiviert. Anschließend wird ein Löcherarray 6 in der Polysiliziumschicht 5 durch Strukturierung mit Hilfe einer Fototechnik und anschließende Ätzung erzeugt. Das Löcherarray 6 dient zum späteren Durchleiten der Ätzflüssigkeit zum Erzeugen des Hohlraums in den unter der Polysiliziumschicht 5 gelegenen Bereichen.

An Stellen, an denen später Nitridstützen erzeugt werden sollen, wird in der Polysiliziumschicht 5 ein angepaßtes, d.h. zur Vermeidung einer Kollision mit dem Cantilver ausreichend großes Loch, erzeugt. Auf diese zweite Polysiliziumschicht 5 wird eine dritte Oxidschicht 7 aufgebracht, planarisiert und verdichtet. Mit einer Fototechnik wird die Oxidschicht 7 strukturiert, so daß sie im Bereich des Pfeils 14 endet und im folgenden Schritt eine weitere, vierte Oxidschicht 8 aufgebracht, die sich über die dritte Oxidschicht und die zweite Polysiliziumschicht 5 erstreckt. Im nächsten Schritt wird eine dritte Polysiliziumschicht 9 aufgebracht, die die Abdeckung des Sensors bildet. Diese wird dotiert und in einem Hochtemperaturschritt rekristallisiert. Dabei werden die Dotierstoffe aktiviert.

Zur Festlegung der Außenabmessungen des Sensors und zur Erzeugung eines Löcherarrays 10 in der dritten Polysiliziumschicht 9 wird mit Hilfe einer Fototechnik die Polysiliziumschicht 9 strukturiert und anschließend an den entsprechenden Stellen geätzt. Über die Fläche verteilt wird in einigen Löchern des Löcherarrays 10 eine trockene, anisotrope Oxidätzung mit einer isotropen Komponente vorgenommen, um in den Oxidschichten einen Hohlraum zu erzeugen, in dem eine Stütze ausgebildet werden kann. Der Hohlraum reicht im wesentlichen senkrecht von der dritten Polysiliziumschicht 9 bis zum Substrat 1 herunter und führt durch das angepaßte und große Loch im Löcherarray 10 der zweiten Polysiliziumschicht 5. Im folgenden wird eine Nitridschicht 11 aufgebracht, die auch den vorher erzeugten Hohlraum unter Bildung einer Nitridstütze 12 füllt. Das Nitrid lagert sich dabei überwiegend an den Wänden an, wodurch sich ein Hohlraum 13 im Inneren der Nitridstütze 12 ergibt. Da die vorhergehende Hohlraumätzung eine isotrope Komponente aufweist, erstreckt sich der Hohlraum und dabei auch die Nitridstütze 12 untergreifend unter die dritte Polysiliziumschicht 9 und stützt diese daher ab.

Zur Durchführung des weiteren Verfahrens wird die Nitridschicht 11 trocken geätzt, so daß sich Löcher 15 vor allem im Bereich des darunter liegenden Löcherarrays 10 bilden. Im nächsten Schritt kann dann durch die Löcher in der Polsiliziumschicht 9 und der Nitridschicht 11 eine isotrope Ätzung der Oxidschichten zur Hohlraumbildung erfolgen. Es wird jedoch zunächst nur an einigen Stellen eine anisotrope trockene Oxidätzung mit einer isotropen Komponente vorgenommen, wodurch weitere Hohlräume 16 gebildet werden. Die isotrope Komponente muß dabei so groß sein, daß der Hohlraum auch Bereiche der zweiten Polysiliziumschicht 5 erfaßt, die den Cantilever bildet. Diese Hohlräume werden bei einer folgenden Fototechnik mit Lack gefüllt, so daß sich in dem Sensor Lackstützen bilden, die während des folgenden Oxidätzens den Cantilever in einer vorgegebenen Position halten und dadurch ein Absinken des Cantilevers 17 vermeiden. Auf diese Weise wird verhindert, daß sich der Cantilever während der Oxidätzung unter Einfluß der Ätzflüssigkeit festsaugt. Nach Ätzung des Hohlraums werden die Lackstützen wieder entfernt.

Die Löcher des Löcherarrays 10, die in der dritten Polysiliziumschicht 9 ausgebildet sind, sind geometrisch kleiner als die Löcher des Löcherarrays 6 in der zweiten Polysiliziumschicht 5, da die erstgenannten Löcher zum Schluß wieder verschlossen werden müssen.

Dabei ergibt sich die in Figur 2 dargestellte Struktur mit dem Lagerpunkt 18, der aus der ersten Polysiliziumschicht 3, die auch als Hilfsschicht bezeichnet wird, gebildet wird, dem Cantilever 17, der aus der zweiten Polysiliziumschicht 5 gebildet wird und der Abdeckung, die im wesentlichen aus der dritten Polysiliziumschicht 9 besteht. Die noch vorhandenen Löcher im Bereich der aus der dritten Polysiliziumschicht 9 gebildeten Abdeckung werden mit einem Oxid oder Borphosphorsilikatglas (BPSG) abgedeckt und verschlossen. An einer geeigneten Stelle wird ein Kontaktloch 20 geätzt und durch dieses ein metallischer Kontakt auf den darunter liegenden Cantilever 17 geführt. Dabei ist darauf zu achten, daß der metallische Kontakt keinen Kontakt mit der Polysiliziumschicht 3 im Bereich des Löcherarrays 6 hat. Dies erfolgt durch eine Unterbrechung 19 der Polysiliziumschicht 3. Der Sensor kann jetzt bestimmungsgemäß durch die sich verändernden Kapazitäten zwischen dem Cantilever 17 und der Polysiliziumschicht 9 einerseits und dem Cantilever 17 und dem Substrat 1 andererseits arbeiten.

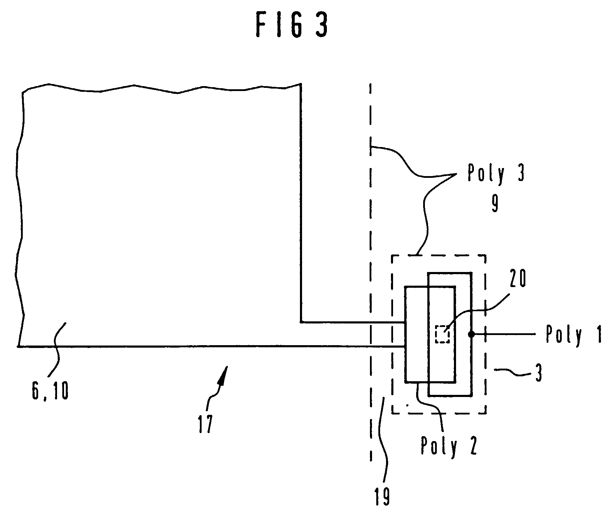

In Figur 3 ist eine Draufsicht auf den Sensor dargestellt, wobei die gestrichelte Linie die äußeren Abmessungen anzeigt, die durch die dritte Polysiliziumschicht 9 bestimmt werden. Die dritte Polysiliziumschicht überdeckt zum einen den Hauptbereich des Cantilevers 17 und zum anderen den rechts unten dargestellten Fortsatz des Cantilevers 17, in dem auch der aus der ersten Polysiliziumschicht 3 gebildete Lagerpunkt 18 angeordnet ist. Die dritte Polysiliziumschicht 9 ist in diesen beiden Bereichen getrennt ausgebildet, um einen elektrischen Kontakt zum Cantilever 17 zu vermeiden. In dem zentralen Bereich des Cantilevers 17 ist sowohl das Löcherarray 6 der zeiten Polysiliziumschicht als auch darüberliegend das Löcherarray 10 der dritten Polysliziumschicht 9 angeordnet.

### Bezugszeichenliste

- 1: Substrat
- 2: erste Oxidschicht
- 3: erste Polysiliziumschicht
- 4: zweite Oxidschicht
- 5: zweite Polysiliziumschicht
- 6: Löcherarray in der zweiten Polysiliziumschicht
- 7: dritte Oxidschicht
- 8: vierte Oxidschicht
- 9: dritte Polysiliziumschicht
- 10: Löcherarray in der dritten Polysiliziumschicht
- 11: Nitridschicht
- 12: Nitridstütze
- 13: Hohlraum in der Nitridstütze
- 14: Pfeil
- 15: Löcherarray in der Nitridschicht
- 16: Hohlraum
- 17: Cantilever
- 18: Lagerpunkt
- 19: Unterbrechung
- 20: Kontaktloch

## Patentansprüche

1. Mikroelektronischer, integrierter Sensor, in dem ein Cantilever (17) ausgebildet ist und der eine Stütze (12) aufweist, die sich zur Abstützung einer oberen Schicht durch einen Hohlraum (16) erstreckt,
dadurch **gekennzeichnet**,
daß die Stütze (12) aus Nitrid besteht.

2. Sensor nach Anspruch 1,
dadurch **gekennzeichnet**,
daß die Stütze (12) in ihrem Inneren einen Hohlraum (13) aufweist.

3. Sensor nach Anspruch 1 oder 2,
**dadurch gekennzeichnet**, daß
der Cantilever (17) an einem Lagerpunkt (18) aufgelegt ist, daß seitliche und obere Bewegungsbegrenzungen vorhanden sind und der Lagerpunkt (18) aus einer als Hilfsschicht verwendeten ersten Polysiliziumschicht (3) gebildet ist.

4. Verfahren zur Herstellung eines mikroelektronischen, integrierten Sensors mit den Schritten:
- Bereitstellen eines Substrats (1);
- Abscheiden mehrerer Oxidschichten auf dem Substrat (1);
- Abscheiden einer Polysiliziumschicht (9) auf den Oxidschichten, zur Bildung einer Abdeckung;
- Bilden eines Löcherarray (10) in der Polysiliziumschicht (9);
- Durchführen einer anisotropen Oxidätzung mit isotroper Komponente an mindestens einem vorgesehenen Loch des Löcherarray (10) für mindestens eine Stütze (12);
- Aufbringen einer Nitridschicht (11), wobei das Nitrid unter Bildung der Stütze (12) in das vorgesehene Loch gelangt;
- Entfernen der Nitridschicht (11), wobei die aus der Nitridschicht (11) gebildete Stütze (12) nicht entfernt wird;
- Durchführen einer Oxidätzung durch die übrigen Löcher des Löchearrays (10) zur Bildung eines Hohlraums (16), durch den sich die Stütze (12) zur Abstützung oberer Schichten erstreckt.

5. Verfahren nach Anspruch 4,
dadurch **gekennzeichnet**,
daß bei einer Strukturierung des Cantilevers (17) im Bereich der Stütze (12) Löcher erzeugt werden, die von der Stütze (12) beabstandet sind.

6. Verfahren nach einem der Ansprüche 4 oder 5,
dadurch **gekennzeichnet**,
daß die Herstellung des Löcherarrays (10) in der Polysiliziumschicht (9) in zwei Schritten durchgeführt wird, wobei nach Ätzung der ersten Löcher eine anisotrope Oxidätzung mit isotroper Komponente durchgeführt wird und die dabei erzeugten Hohlräume bei einer Lackaufbringung zur Strukturierung der zweiten Löcher unter Bildung von Lackstützen mit Lack gefüllt werden.

7. Verfahren nach einem der Ansprüche 4 bis 6,
dadurch **gekennzeichnet**,
daß ein Lagerpunkt (18), auf dem der Cantilever (17) aufgelegt ist, aus einer als Hilfsschicht verwendeten ersten Polysiliziumschicht (3) gebildet wird.

## Revendications

1. Capteur microélectronique intégré dans lequel est formé un cantilever (17) et qui présente un appui (12), qui s'étend, en vue du soutien d'une couche supérieure, dans une cavité (16), caractérisé en ce que l'appui (12) est constitué de nitrure.

2. Capteur selon la revendication 1, caractérisé en ce que l'appui (12) présente une cavité (13) intérieure.

3. Capteur selon la revendication 1 ou 2, caractérisé en ce que le cantilever (17) repose sur un point de support (18), en ce que des limitations de mouvements latérales et supérieures sont présentes et en ce que le point de support (18) est formé à partir d'une première couche de polysilicium (3) utilisée à titre de couche auxiliaire.

4. Procédé de fabrication d'un capteur microélectronique intégré présentant les étapes :
- de fourniture d'un substrat (1);
- de dépôt de plusieurs couches d'oxyde sur le substrat (1);
- de dépôt d'une couche de polysilicium (9) sur les couches d'oxyde, en vue de la formation d'un recouvrement ;
- de formation d'une matrice de perforations (10) dans la couche de polysilicium (9) ;
- de réalisation d'une gravure d'oxyde anisotrope avec une composante isotrope à au moins une perforation prévue de la matrice de perforations (10) pour au moins un appui (12) ;
- d'application d'une couche de nitrure (11), le nitrure parvenant dans la perforation prévue, en formant l'appui (12) ;
- d'élimination de la couche de nitrure (11) sans éliminer l'appui (12) formé à partir de la couche de nitrure (11) ;
- de réalisation d'une gravure d'oxyde par les autres perforations de la matrice de perforations (10) en vue de la formation d'une cavité (16), dans laquelle s'étend l'appui (12) en vue du soutien des couches supérieures.

5. Procédé selon la revendication 4, caractérisé en ce qu'on réalise lors d'une structuration du cantilever (17) dans la région de l'appui (12) des perforations qui se trouvent à une certaine distance de l'appui (12).

6. Procédé selon l'une des revendications 4 ou 5, caractérisé en ce que la réalisation de la matrice de perforations (10) dans la couche de polysilicium (9) est effectuée en deux étapes, en effectuant après la gravure des premières perforations, une gravure d'oxyde anisotrope avec une composante isotrope et en remplissant de laque les cavités résultantes, lors d'une application de laque en vue de la structuration des deuxièmes perforations, en formant des appuis de laque.

7. Procédé selon l'une des revendications 4 à 6, caractérisé en ce qu'on forme un point de support (18) sur lequel repose le cantilever (17) à partir d'une première couche de polysilicium (3) utilisée à titre de couche auxiliaire.

## Claims

1. Micro-electronic integrated sensor in which a cantilever (17) is formed and which has a support (12) which extends through a cavity (16) to support an upper layer,
characterised in that
the support (12) consists of nitride.

2. Sensor in accordance with Claim 1,
characterised in that
the support (12) has a cavity (13) within it.

3. Sensor in accordance with Claims 1 or 2,
characterised in that
the cantilever (17) is laid on a seating point (18), that sideways and upwards movement stops are present and the seating point (18) is formed from a first polysilicon layer (3) formed as an auxiliary layer.

4. Method for manufacture of a micro-electronic, integrated sensor with the following stages:
- Provision of a substrate (1),
- Deposition of several oxide layers on the substrate (1),
- Deposition of a polysilicon layer (9) on the oxide layers to form a cover,
- Formation of a hole array (10) in the polysilicon layer (9),
- Performance of an anisotropic oxide etching with an isotropic component at at least one provided hole of the hole array (10) for at least one support (12),
- Application of a nitride layer (11), whereby the nitride is introduced into the hole provided, forming the support (12),
- Removal of the nitride layer (11) whereby the support (12) formed from the nitride layer (11) is not removed,
- Performance of an oxide etching through the remaining holes of the hole array (10) to form a cavity (16) through which the support (12) extends to support the upper layers.

5. Method in accordance with Claim 4,
characterised in that,
holes are created by a structuring of the cantilever (17) in the area of the support (12), which have a clearance from the support (12).

6. Method in accordance with one of Claims 4 or 5,
characterised in that,
the manufacture of the hole array (10) in the polysilicon layer (9) is carried out in two stages, whereby after etching of the first holes an anisotropic oxide etching with an isotropic component is performed and the cavities thus created are filled with varnish by applying varnish for the structuring of the second holes, forming varnish supports.

7. Method in accordance with one of Claims 4 to 6,
characterised in that,
a seating point (18) on which the cantilever (17) is laid is formed from a first polysilicon layer (3) used as an auxiliary layer.
